# EUROPÄISCHE PATENTANMELDUNG

(11) **EP 3 154 081 A2**
(43) Veröffentlichungstag der Anmeldung: **12.04.2017**
(21) Anmeldenummer: 16001365.2
(22) Anmeldetag: 17.06.2016
(51) Int. Cl.: H01L 23/373, H01L 23/498, H01L 21/48, H01L 23/495, H01L 23/64

(54) **VERFAHREN ZUM HERSTELLEN VON ELEKTRONISCHEN MODULEN MIT ANBINDUNG EINES METALLISCHEN BAUTEILS ZU KERAMISCHER OBERFLÄCHE EINES SUBSTRATS MITTELS METALLPULVERBASIERTER PASTE**

(30) Priorität: 16.09.2015 DE 102015115611
(71) Anmelder: Karlsruher Institut für Technologie, 76131 Karlsruhe (DE)
(72) Erfinder: Meißer, Michael, 76137 Karlsruhe (DE); Leyrer, Benjamin, 76185 Karlsruhe (DE); Blank, Thomas, 76187 Karlsruhe (DE)
(74) Vertreter: Weddigen, Andreas

(57) **Zusammenfassung**

Ein Verfahren, aufweisend: Bereitstellen mindestens eines Substrats (210) mit keramischer Oberfläche (220), einer druckfähigen, metallpulverbasierten Paste (230), sowie eines metallischen Bauteils (240); Auftragen einer Schicht, bestehend aus der Paste (230) auf einen Bereich der Oberfläche (220) und/oder des Bauteils (240); Auflegen des Bauteils (240) auf die keramische Oberfläche (220) mit dazwischen angeordneter genannter Schicht (230); Andrücken des Bauteils (240) in die Schicht (230); Trocknen der Paste (230) bei einer derart angepassten Temperatur, dass einerseits die Verdünnungsmittel der Paste (230) verdampfen und andererseits die organischen Bestandteile der Paste (230) dabei nicht verbrennen; sowie Sintern der Paste (230) bei einer Temperatur unterhalb der jeweils geringeren Schmelztemperatur der beiden zu sinternden Komponenten (210, 240), zu einer elektrisch und thermisch leitfähigen Schicht mit flächiger und stoffschlüssiger Anbindung zu dem metallischen Bauteil (240) und zu der Oberfläche (220). Die keramische Oberfläche (220) des Substrats (210) kann aus einer Oxidkeramik und das mindestens eine metallische Bauteil (240) aus Kupfer bestehen, wobei das Sintern in einer vorwiegend inerten Atmosphäre erfolgt. Das metallische Bauteil (240) kann strukturiert und/oder mechanisch verformt werden, wobei das metallische Bauteil (240) zumindest zwei Bereiche der keramischen Oberfläche (220) und/oder einer metallischen Oberfläche eines zweiten metallischen Bauelements elektrisch verbindet. Es können zusätzlich eine druckfähige, nichtmetallpulverbasierte Paste oder zusätzlich eine druckfähige, metallpulverbasierte Paste in einer oder mehreren Schichten auf der druckfähigen, metallpulverbasierten Paste (230) übereinander aufgebracht werden. Ein zweites metallisches Bauteil kann auf eine auf das erste metallische Bauteil (240) aufgebrachte druckfähige, nichtmetallpulverbasierte oder metallpulverbasierte Paste aufgelegt und eingedrückt werden. Das Substrat (210) kann auch ein Metall-Keramikverbund sein.

## Beschreibung

Die Erfindung betrifft ein Verfahren zum Herstellen von elektronischen Modulen bzw. Baugruppen, d.h. es wird hierin ein Verfahren offenbart, welches ein Verbinden von elektronischen Komponenten zu einem Modul bzw. einer Baugruppe ermöglicht.

Das betreffende technische Gebiet umfasst bspw. ein Verfahren zum Herstellen von einer Struktur bzw. mehreren Strukturen von Leistungshalbleitermodulen, wie sie z.B. in Invertern für Windkraftanlagen, Motoren für industrielle Maschinen und Traktionsanwendungen im Bereich der Elektromobilität zum Einsatz kommen. Die Spannungsklasse dieser Module liegt im Bereich von 40 V bis 4000 V bei einem Leistungsbereich von 1 kW bis 1000 kW. Leistungshalbleitermodule bestehen klassisch aus einer Grundplatte, einem metallisierten keramischen Substrat (DCB) und den aufgelöteten Leistungshalbleiterchips (sogenannte Dies), welche oberseitig mit Bondverbindungsdrähten (Bondwires) kontaktiert sind. Wesentliche Eigenschaften der Modulstruktur sind hohe Wärmespreiz- und Wärmeleitfähigkeit bei gleichzeitig hoher Widerstandsfähigkeit gegen elektrische Durchschläge, hohe elektrische Leitfähigkeit der leitenden Komponenten und relativ hohe parasitäre Induktivität der elektrischen Verschaltung. Die Leistungsdichte leistungselektronischer Module entscheidet über die Breite ihres Anwendungsbereiches und ist ein wichtiges Differenzierungsmerkmal der unterschiedlichen Modulklassen verschiedener Hersteller. Die Erhöhung der Leistungsdichte erfordert eine Steigerung der thermischen Leitfähigkeit des thermischen Pfades sowie die Verringerung der parasitären Induktivitäten. Letzteres erlaubt die Erhöhung der Betriebsfrequenz, was dazu führt, dass elektrische und magnetische Energiespeicherelemente bezüglich ihrer Abmessungen und ihres Gewichtes kompakter ausgelegt werden können. Derzeit steht für leistungselektronische Module lediglich eine keramische Substrattechnologie zur Verfügung - das Direct Copper Bond Substrat (DCB). Alternative Forschung und Entwicklung dazu zielt auf sogenannte Dickschichtsubstrate ab. Diese bestehen aus einem keramischen Träger, auf welchen mittels Siebdruck Dickfilmpasten aufgebracht werden. Diese werden bei Temperaturen von ungefähr 950 °C eingebrannt. Leitfähige Dickfilmpasten können dabei aus Silber- oder Kupferpartikeln bestehen. Darüber hinaus sind auch isolierende Pasten verfügbar. Zu beachten ist, dass das Einbrennen von Kupferpasten unter Schutzatmosphäre (bspw. Stickstoff N₂) erfolgen muss, um eine Oxidation zu verhindern. Im Gegensatz zu DCBs bieten Dickfilmsubstrate die Möglichkeit, durch mehrmaligen Druck unterschiedlicher Layouts Multilagenschaltungen herzustellen. Dadurch ist es möglich, Masseflächen und Leiterbahnkreuzungen zu integrieren. Darüber hinaus kann die Strukturauflösung (DCB: 500 µm) auf 200 µm reduziert werden. Die damit möglichen feineren Strukturen erlauben den Anschluss von Integrierten Schaltungen (ICs) mit sehr dichten Anschlussabständen. Dickfilmpasten erlauben damit die Verwirklichung von Hochstrombereichen mit hoher Schichtdicke und Feinleiterbereichen mit geringer Schichtdicke auf einem einzigen Substrat - und somit deren Integration in ein leistungselektronisches Modul. Problematisch am Stand der Technik (Dickfilmmodule) ist der hohe Aufwand, um Schichtdicken bis zu 300 µm aufzubauen. Hierzu sind bis zu 6 Druck- und Einbrennprozesse notwendig, welche eine hohe Produktionszeit und eine hohe Anzahl an Prozessschritten benötigen. Darüber hinaus treibt der hohe Preis von Kupferpasten die Produktionskosten für derartige Module bzw. Baugruppen in die Höhe.

Die Aufgabe besteht somit im Bereitstellen eines Verfahrens, welches die Integration verschiedener Metallisierungsschichtdicken auf einem Substrat mit im Vergleich zum Dickfilmansatz reduzierten Kosten ermöglicht.

Die Aufgabe wird mit einer Vorrichtung gemäß den Merkmalen von Patentanspruch 1 gelöst. Hierauf bezogene Unteransprüche geben vorteilhafte Ausgestaltungen wieder.

Das Problem der hohen Produktionskosten von kupferbasierten Dickfilmstrukturen wird gelöst durch die Kombination der Dickfilmtechnik mit vorgefertigten leitfähigen Elementen auf Kupferbasis. Hierzu wird auf einem Substrat lediglich eine vergleichsweise dünne, d.h. mit einer Schichtdicke in einem Bereich von 20 µm bis 80 µm, Dickfilmschicht mit einem Siebdruckverfahren aufgebracht. Aufgrund der geringen Dicke der Schicht kann eine hohe Druckauflösung bis hinunter zu 200 µm erreicht werden. Vor dem Trocknen der Schicht werden auf die noch nasse Paste in Bereichen Kupferplättchen mit einer Dicke im Bereich von 50 µm bis 300 µm aufgesetzt und durch (bspw. kurzzeitig) applizierten Druck bspw. bis zu einem Drittel der Dickfilmschichtdicke in diese eingedrückt. Danach wird dieser Schichtaufbau getrocknet und unter Stickstoffatmosphäre bei Temperaturen in einem Bereich von ungefähr 900 °C bis zu ungefähr 1000 °C, bzw. in einem Bereich von ungefähr 925 °C bis zu ungefähr 975 °C, bzw. bei einer Temperatur von ungefähr 950 °C eingebrannt. Die KupferDickfilmschicht geht dabei eine intermetallische Bindung mit dem Kupferplättchen sowie eine oxidische Bindung mit dem beispielsweise aus Aluminiumoxid (AL₂O₃) bestehenden Substrat ein, wobei das Substrat z.B. auch aus mindestens einer Oxidkeramik aus der Gruppe von Oxidkeramiken gebildet sein kann, wobei die Gruppe von Oxidkeramiken aufweist:
Aluminiumoxid (Al₂O₃, Zirconiumdioxid (ZrO₂),
Titan(IV)-Oxid (TiO₂), Magnesiumoxid (MgO), Zinkoxid (ZnO), Aluminiumtitanat (Al₂O₃ + TiO₂) und Bariumtitanat (BaO + TiO₂). Auf die Kupferplättchen kann mittels Schablonen- oder Siebdruck Silbersinterpaste oder Lötpaste aufgetragen werden, mit der ein Leistungshalbleiterchip unterseitig kontaktiert werden kann. Die oberseitige Kontaktierung des Halbleiterchips kann über Drahtbonds erfolgen.

Darüber hinaus können in weiteren Ausführungsformen des Verfahrens vor oder nach Aufsetzen der Kupferplättchen weitere Dickfilmstrukturen aufgebracht werden, die vorzugsweise Multilagenschaltungen abbilden und damit die Integration anderer Schaltungsteile, bestehend aus Schaltungselementen wie Kondensatoren oder ICs, erlauben. Multilagenschaltungen werden durch die Verwendung von Dickschicht-ISO-Pasten möglich, die die elektrische Isolation zwischen den einzelnen Leiterlagen gewährleisten. Auf den fertig prozessierten Kupferplättchen, bzw. Dickfilmoberflächen können mittels verschiedener Niedertemperaturverfahren (wie bspw. Löten, Kleben und/oder Sintern) andere Schaltungsträger oder Schaltungselemente aufgebracht werden. Die Kupferplättchen sorgen hierbei für:
- Wärmespreizung unterhalb der leistungselektronischen Halbleiterchips
- einen ausreichenden Leiterquerschnitt in Bereichen mit hoher Stromdichte (unterhalb der Chips, in der Nähe von Kontaktstellen) und somit Sicherstellung der notwendigen Stromtragfähigkeit
- Oberflächen hoher spezifischer Dichte und damit guter Bond- und Sinterbarkeit

Die Dickfilmschicht übernimmt erstmals die folgenden kombinierten Aufgaben:
- Haftung auf oxidischem Substrat
- Haftung zu kupfernem Metallplättchen
- Abbildung einer Leiterstruktur (Layout)
- Abbildung eines Mehrlagen-Layouts

Während reine Sinterpasten nur die Haftung zu Metallen aufbauen können, werden Dickfilmschichten hier erstmals genutzt, um sowohl Haftung zu einer oxidischen Keramik als auch zu einem metallenem Plättchen aufzubauen. Die Plättchen bestehen vorzugsweise aus Kupfer, Kupferlegierungen oder anderen mit einer Kupferoberfläche versehenen Metallen. Wie bereits bekannt, kann die Dickfilmschicht darüber hinaus auch die Aufgabe übernehmen, Leiterstrukturen in Form eines Layouts abzubilden.

Derzeit gibt es einen einzigen Hersteller, welcher auf Dickfilmtechnik basierende Module im Programm hat. Allerdings handelt es sich dabei nicht um Kupfer- sondern um Silberdickfilme. Kupferdickfilme werden bisher nicht kommerziell in Leistungselektronikmodulen eingesetzt. Dickfilme werden bisher nicht zur Verbindung von keramischen und kupfernen Komponenten eingesetzt. Leistungselektronische Module und deren Struktur, insbesondere die Substratstruktur betreffend, sind dem Stand der Technik zufolge durch folgende Nachteile gekennzeichnet: Das Substrat wird nur teilweise in einem Hochtemperaturprozess hergestellt. Zum Beispiel wird die Metallisierung der DCBs bei über 1000 °C aufgebracht, die Strukturierung erfolgt dann jedoch durch einen Ätzprozess. Verbindungen zu Verbindungselementen (Steckverbinder, Brücken) müssen unter Nutzung dritter Substanzen hergestellt werden (Lötzinn, Kleber, Sinterpaste), welche eine unterschiedliche Wärmeausdehnung aufweisen. Substrate erlauben nicht die gleichzeitige Anordnung von dünnen, feinen Leiterstrukturen und dicken Leiterbereichen mit großem Leiterquerschnitt auf einem einzigen Substrat. Dieses wäre mit der Kupferdickfilmtechnik möglich, jedoch unter erheblichen Kosten, da bis zu sechs Kupferdickfilmpastendrucke notwendig sind, um eine Schichtdicke von 300 µm zu erreichen. Große räumliche Ausdehnung der Module durch getrennte diskrete Bauteile für Stromzuführung und Energiespeicherung. Da die Integration aktiver und passiver Bauteile derzeit nur sehr schwer möglich ist, kann die Leistungsdichte der leistungselektronischen Systeme nicht optimiert werden.

Erstmals kann somit ein druckbares Medium genutzt werden, um neben einem Schaltungslayout in einem Zug auch die elektrische und mechanische Verbindung zwischen Substrat und Schaltungskomponenten herzustellen. Bisher wurde die Kupferdickfilmtechnik hierfür nicht genutzt, d.h. um keramische Schaltungsträger mit Metallteilen zu verbinden, bzw. um keramische Schaltungsträger untereinander oder mit DCBs zu verbinden, bzw. um induktive Bauelemente herzustellen, bzw. um induktive Bauelemente mit einem keramischen Substrat zu verbinden. Die sich daraus ergebenden Vorteile sind ein signifikanter Produktionskostenvorteil (wie z.B. Material, da Pasten sehr teuer sind) gegenüber Substraten, die mittels Dickfilmtechnik auf die Metallisierungen mit Schichtdicken im Bereich von 300 µm aufgebracht werden. Darüber hinaus besteht auch ein Kostenvorteil durch schnellere und flexiblere Produktion, d.h. Metallplättchen können mit Standard-Bestückungsautomaten auf dem Dickfilm platziert werden. Des Weiteren können die Abmessungen der Plättchen standardisiert werden, um Anforderungen sowohl an die Wärmespreizung als auch an die maschinelle Verarbeitung zu genügen. Außerdem wird die thermische Performance von Modulen gesteigert, die auf kostengünstigem Aluminiumoxidsubstrat basieren und die maximale Leistungsdichte kann erhöht werden. Zusätzlich kann die Integrationsdichte gesteigert werden, d.h. kompaktere Systeme, da ein wesentlicher, d.h. hochfrequenzfähiger, Teil des Zwischenkreiskondensators auf dem Modulsubstrat integrierbar ist und somit parasitäre Eigenschaften, im Vergleich zu einem auf DCB-Substrat basierenden Modul, verringert werden können. Weiterhin bestehen Kupferbaüteile (z.B. Plättchen, Verbindungselemente etc.) und Dickfilmpasten in erster Linie aus demselben Material, was den mechanischen Stress, ausgelöst durch Temperatur-Wechselbelastung, reduziert und Dickfilmbrennprozesse sind nicht reversibel, wodurch komplexe Strukturen sequentiell, d.h. mit mehreren Druck-, Bestückungs- und Brennprozessen gefertigt werden können. Diese komplexen Strukturen können insbesondere auch signifikante Ausdehnungen in eine zur Oberflächennormale des Substrates parallelen Richtung aufweisen. Außerdem arbeitet man bei einem Dickfilmverbindungsprozess - verglichen mit Sinterprozessen - im Wesentlichen drucklos, da zu verbindende kupferne oder keramische Teile nur kurz in die verbindende Kupferdickfilmpaste gedrückt werden - weshalb ein Druckaufbau während der Trocknungs- und Brennphase nicht notwendig ist. Daher können auch Keramiken mit komplexerer Formgebung, bspw. mit eingebetteten Kühlstrukturen, verarbeitet werden. Eine Beschichtung (bspw. Versilberung) der zu verbindenden kupfernen Bauteile oder die Verwendung von aggressiven Chemikalien, wie z.B. Flussmittel, ist nicht erforderlich. Des Weiteren bestehen zu verbindende Kupferbauteile und die zu verbindende Kupferdickfilmpaste aus demselben Element und weisen daher stark übereinstimmende physikalische Eigenschaften (wie z.B. Wärmeausdehnung, elektrische Leitfähigkeit, Stromtragfähigkeit etc.) auf.

Diese genannten Vorteile bewirken eine Steigerung der Systemleistungsdichte durch Verbesserung der Wärmetransportleistung (Wärmespreizung) und Erhöhung der möglichen Betriebsfrequenz (geringere parasitäre Induktivität). Außerdem eine Reduzierung des Leistungsgewichtes durch Erhöhung der Betriebsfrequenz und damit Verkleinerung der elektrischen und magnetischen Speicherelemente und eine Reduzierung der Produktionskosten von leistungselektronischen Modulen durch geringeren Materialaufwand, kürzere Produktionszeit und kompaktere Abmessungen der Module.

Eine Ausführungsform des Verfahrens ist bspw. dadurch gekennzeichnet, dass das Hauptsubstrat des Leistungselektronikmoduls aus einer Keramik besteht, auf welcher durch einen additiven Prozess wie Sieb- oder Schablonendruck, bzw. Direktschreibverfahren (z.B. Inkjet) eine Kupferdickfilmpaste aufgetragen wird und auf diese noch nasse Paste ein oder mehrere Kupferplättchen gelegt und/oder angedrückt werden. Durch den nachfolgenden Trocknungs- und Einbrennprozess wird eine elektrische Verbindung zwischen Dickfilmpaste und Kupferplättchen sowie eine mechanische Verbindung zwischen keramischem Substrat, Dickfilmschicht und Kupferplättchen erreicht, wodurch eine kraft- und formschlüssige Verbindung zwischen keramischem Substrat, Dickfilmschicht und Kupferplättchen gebildet wird. Hierdurch wird erreicht, dass die Eigenschaft der Dickfilmschicht, aufgrund ihrer Porosität mechanischen Stress bzw. Spannung zwischen Substrat und Kupferplättchen abzubauen, für das zu bildende Modul bzw. die Baugruppe genutzt wird. Weiterhin können die Dickfilmschichten auf alle Oberflächen des Kupferplättchens aufgebracht werden. Somit steht nicht nur die Unterseite des Kupferplättchens in direktem Kontakt mit einer Dickfilmpaste, sondern Dickfilmpasten können auch auf die Plättchenoberseite aufgebracht werden. Generell können so elektrisch leitfähige, elektrisch nicht leitfähige, sowie widerstandsbehaftete Schichten zur Anwendung kommen. Darüber hinaus können die Plättchen sowohl in der Ebene ihrer längsten Abmessungen wie auch ihrer Dicke beliebig geformt sein. Vorteilhaft sind dabei auch Einkerbungen an den Rändern um thermisch induzierten mechanischen Stress bzw. Spannung abzubauen. D.h. sowohl auf Kupferdickfilmschichten wie auch auf den darauf aufgebrachten Kupferplättchen können bspw. (Silber-) Sinterpasten appliziert werden, welche die elektrische und thermische Verbindung zu Leistungshalbleiterchips herstellen.

Eine Ausführungsform betrifft ein Verfahren, aufweisend folgende Verfahrensschritte: Bereitstellen mindestens eines Substrats, wobei mindestens eine erste Oberfläche des Substrats zumindest teilweise eine keramische Oberfläche aufweist, und mindestens eine druckfähige, metallpulverbasierte bzw. metallpulverbasierende Paste, sowie mindestens ein metallisches Bauteil; Auftragen mindestens einer Schicht, bestehend aus der mindestens einen druckfähigen, metallpulverbasierten Paste, welche Verdünnungsmittel und organische Bestandteile aufweist, auf mindestens einen Bereich der keramischen Oberfläche und/oder auf mindestens einen Bereich des mindestens einen metallischen Bauteils; Auflegen des mindestens einen metallischen Bauteils auf die keramische Oberfläche mit mindestens einer zumindest teilweise dazwischen angeordneten Schicht der metallpulverbasierten Paste; Andrücken des mindestens einen metallischen Bauteils in die mindestens eine Schicht; Trocknen der mindestens einen druckfähigen, metallpulverbasierten Paste in der mindestens einen Schicht bei einer derart angepassten Temperatur, dass einerseits die Verdünnungsmittel der Paste verdampfen und andererseits die organischen Bestandteile der Paste dabei nicht verbrennen; sowie Sintern der mindestens einen druckfähigen, metallpulverbasierten Paste in der mindestens einen Schicht bei einer Temperatur unterhalb der jeweils geringeren Schmelztemperatur der zu sinternden metallischen Komponenten, bestehend aus dem mindestens einen metallischen Bauteil und der mindestens einen druckfähigen, metallpulverbasierten Paste mit mindestens einem zu sinternden Metallpulver und der mindestens einen keramischen Oberfläche zu einer elektrisch und thermisch leitfähigen Schicht mit flächiger und stoffschlüssiger Anbindung zu mindestens einem metallischen Bauteil und zu der mindestens einen keramischen Oberfläche. Die Herstellung eines solchen Verbundes aus Oxidkeramik und metallischem Bauteil erfolgt mit Hilfe einer metallpulverbasierten Dickfilmpaste, die in einem Hochtemperaturprozess mittels Sinterns mindestens zwei Komponenten kraftschlüssig und elektrisch leitend sowie thermisch leitend verbindet. Ein Vorteil der hierbei eingesetzten hohen Temperatur besteht darin, dass nachfolgende Prozesse mit Temperaturen unterhalb ca. 600 °C keinerlei Einfluss auf die in diesem Verfahren hergestellte Verbindung haben. Weiterhin erreichen Temperaturen während des Betriebs des Leistungsmoduls basierend auf der erfindungsgemäßen Struktur in der Regel höchstens 300 °C und liegen damit weit außerhalb von Temperaturen, die wesentliche Eigenschaften der Struktur (wie bspw. elektrische Leitfähigkeit, mechanische Festigkeit, etc.) kurzfristig negativ verändern könnten. Durch Auflegen des metallischen Bauteils mit typischen Dicken zwischen 50 µm und 1000 µm auf eine Dickfilmschicht oder mehrere Dickfilmschichten mit einer jeweiligen Dicke zwischen 10 µm und 100 µm kann die Dicke der gesamten leitfähigen Schicht mit wenigen Prozessschritten signifikant gesteigert werden. Hieraus resultiert, dass die so geschaffene höhere Dicke der elektrisch leitfähigen Schicht die Stromtragfähigkeit sowie das Wärmespreizvermögen dieser Schicht erhöht.

In einer weiteren Ausführungsform weist das Verfahren ferner auf: anschließendes Aufbringen und stoffschlüssiges Verbinden mindestens eines Schaltungsträgers und/oder mindestens eines Schaltungselements und/oder mindestens einer elektronischen Baugruppe auf das mindestens eine metallische Bauteil und/oder auf Bereiche der druckfähigen, metallpulverbasierten Paste, welche nicht durch das mindestens eine metallische Bauteil und/oder einen Bereich der keramischen Oberfläche bedeckt sind; und wobei das stoffschlüssige Verbinden des mindestens einen metallischen Bauteils und/oder auf Bereiche der druckfähigen, metallpulverbasierten Paste, welche nicht durch das mindestens eine metallische Bauteil und/oder einen Bereich der keramischen Oberfläche bedeckt sind, mit dem mindestens einen Schaltungsträger und/oder dem mindestens einen Schaltungselements und/oder der mindestens einen elektrischen Baugruppe bei einer Temperatur unterhalb der Schmelztemperatur der jeweils geringeren Schmelztemperatur der beiden zu sinternden Komponenten, bestehend aus dem mindestens einen metallischen Bauteil und der mindestens einen druckfähigen, metallpulverbasierten Paste, erfolgt. Durch das Aufbringen von elektrischen oder elektronischen Bauteilen oder Baugruppen wird die Integrationsdichte der erfindungsgemäßen Schichtstruktur und damit des leistungselektronischen Moduls gesteigert. Bereits wenn nur eine Verbindungslage (bspw. metallisches Bauelement und daran angebundene Dickschichtstruktur) vorhanden ist, lassen sich damit elektrische Verbindungsstrukturen einem Schaltplan entsprechend herstellen und Bauelemente-Anschlüsse können über leitende Verbindungen verbunden werden. Dabei ist es typisch für den Sinterprozess, dass das Material nicht aufgeschmolzen wird und es auch nicht zur Ausbildung einer Eutektischen Verbindung kommt. Gesintertes Metallpulver verfügt über eine geringere Dichte als Vollmaterial und weist daher eine gewisse Flexibilität auf. Diese kann hinsichtlich der Zuverlässigkeit des Stoffverbundes vorteilhaft sein, da durch unterschiedliche Temperaturen und temperaturabhängige Ausdehnungskoeffizienten induzierte mechanische Spannungen geringere Amplituden aufweisen, bzw. in nicht destruktive Verformung abgeleitet werden.

In einer weiteren Ausführungsform erfolgt ferner bei dem Verfahren das stoffschlüssige Verbinden mittels mindestens einer Verbindungstechnik aus der Gruppe von Verbindungstechniken, wobei diese Gruppe von Verbindungstechniken aufweist: Löten, Kleben und/oder einen diffusionsgesteuerten Prozess. Eine Präzisierung der Verbindungsart zwischen Struktur und zusätzlichen Bauelementen und Baugruppen weist dabei auf, dass durchweg die hierzu eingesetzten Prozesse im Vergleich zum Dickfilmsintern nur eine niedrige Prozesstemperatur erfordern und somit die Dickfilmverbindungen nicht beeinflussen. Die Dickfilmverbindungen sind somit bezüglich der Prozesstemperatur "abwärtskompatibel".

In einer weiteren Ausführungsform besteht bei dem Verfahren die mindestens eine keramische Oberfläche des mindestens einen Substrats aus einer Oxidkeramik und das mindestens eine metallische Bauteil aus Kupfer und/oder einer Kupferlegierung, wobei die druckfähige, metallpulverbasierte Paste beim Sintern eine metallische Verbindung mit dem mindestens einen metallischen Bauteil und eine adhäsive und/oder oxidische Verbindung mit der mindestens einen keramischen Oberfläche eingeht; und wobei das Sintern in einer vorwiegend inerten Atmosphäre erfolgt. Durch die Verwendung von Kupfer ergibt sich ein Kostenvorteil beim Herstellen gegenüber der Verwendung von Silber. Ein weiterer Vorteil ergibt sich hinsichtlich des thermischen Ausdehnungskoeffizienten der Bauelemente daraus, dass Kupfer auf Kupfer aufgebracht wird, wodurch geringerer mechanischer Stress bzw. Beanspruchung auf die Komponenten wirkt. Hierbei ist wiederum ein Vorteil, dass Metalle sowohl (hier z.B. Kupfer) untereinander wie auch mit Keramiken verbunden werden können.

In einer weiteren Ausführungsform erfolgt in dem Verfahren das Auftragen der mindestens einen druckfähigen, metallpulverbasierten Paste mittels eines Siebdruckverfahrens oder/und eines Direktschreibverfahrens. Daraus ergibt sich wiederum ein Kostenvorteil beim Herstellen und weiterhin lässt sich hinsichtlich hoher erzielbarer Schichtdicken mittels eines Druckvorgangs (bis 100 µm) mit grobem Sieb oder hoher Druckauflösung durch Nutzung feiner Siebe die Prozesseffizienz steigern. Es ist möglich, dass höhere Kosten pro gedrucktem/geschriebenem Pasten-Volumen beim Herstellen verursacht werden, wobei hierbei aber wiederum mehr Freiheiten bezüglich der Oberflächenstruktur des zu beschichtenden Bauteils ermöglicht werden, d.h. Direktschreibverfahren wie Inkjetschreiben sind auch auf unterschiedliche Ebenen des Substrates möglich, bspw. können Gräben mit elektrisch nicht leitfähiger Dickfilmpaste ausgefüllt werden.

In einer weiteren Ausführungsform wird das mindestens eine metallische Bauteil im Anschluss an das Auflegen zumindest bereichsweise parallel zu der mindestens einen keramischen Oberfläche ausgerichtet und dabei während des Auflegens Druck auf das mindestens eine metallische Bauteil in Richtung des mindestens einen Substrats ausgeübt. Planparalleles Auflegen ist notwendig, um so die formschlüssige, mechanisch belastbare sowie elektrisch und thermisch leitfähige Verbindung zwischen metallischem Bauteil und druckfähiger, metallbasierter Paste während des Sinterprozesses bereitzustellen. Jedoch muss nicht die gesamte Oberfläche des metallischen Bauteils, insbesondere nicht die gesamte der keramischen Oberfläche zugewandten Oberfläche des metallischen Bauteils auch planparallel orientiert sein. Die Oberflächenbereiche, die nicht zur Verbindung zwischen Keramik und metallischem Bauteil dienen, können auch andere Funktionen übernehmen, beispielsweise elektrische oder elektronische Bauelemente aufnehmen oder als AnschlussElement verwendet werden.

In einer weiteren Ausführungsform wird bzw. werden zusätzlich, zumindest teilweise, mindestens eine druckfähige, nichtmetallpulverbasierte Paste oder zusätzlich eine druckfähige, metallpulverbasierte Paste in einer Schicht oder mehreren Schichten auf der druckfähigen, metallpulverbasierten Paste übereinander aufgebracht. Hierdurch können sogenannte Multi-Layer Schaltungsträger realisiert werden. Diese erlauben die Abbildung komplexer Schaltpläne mittels mehrlagiger Leiterstrukturen, die durch Isolationsschichten elektrisch voneinander isoliert werden. Dies entspricht dem Konzept von herkömmlichen Leiterplatten, wobei im Unterschied zu diesen, bzw. es demgegenüber vorteilhaft ist, bei der erfindungsgemäßen Struktur, dass eine elektrische Isolation mittels keramischer oder/ und glasartiger Materialien statt organischer Materialien bereitgestellt wird, wodurch wiederum eine hohe Temperaturbeständigkeit und eine hohe Durchschlagsfestigkeit erzielt wird. Außerdem ermöglicht das Verfahren einen geringeren thermischen Ausdehnungskoeffizient und somit geringeren mechanischen Stress bzw. geringere Beanspruchung an Verbindungstellen und an Materialverbund bzw. -verbünde oder an aufgebrachte Bauelemente wie bspw. Leistungshalbleiterchips und/oder oberflächenmontierbare elektronische Bauelemente (SMDs).

In einer weiteren Ausführungsform wird zusätzlich, zumindest teilweise, mindestens ein zweites metallisches Bauteil auf eine auf mindestens ein erstes metallisches Bauteil aufgebrachte druckfähige, nichtmetallpulverbasierte Paste oder eine druckfähige, metallpulverbasierte Paste aufgelegt und eingedrückt. Multilagen können zumindest auch teilweise aus metallischen Bauelementen bestehen, die übereinander mittels leitfähiger oder nicht leitfähiger Paste verbunden werden. Auf diese Art und Weise können neben Mutilagenschaltungen auch Sandwichstrukturen aufgebaut werden, die ähnlich zu DCBs vorteilhafte mechanische Eigenschaften aufweisen.

In einer weiteren Ausführungsform wird das mindestens eine metallische Bauteil vor oder/und nach dem Auflegen auf die druckfähige, metallpulverbasierte Paste mittels mindestens eines mechanischen oder/und chemischen Prozesses strukturiert und/oder mechanisch verformt, wobei das mindestens eine metallische Bauteil nach dem Auflegen auf die druckfähige, metallpulverbasierte Paste zumindest zwei Bereiche zumindest einer keramischen Oberfläche und/oder zumindest einer metallischen Oberfläche eines zumindest zweiten metallischen Bauelements mechanisch oder mechanisch und elektrisch verbindet. Metallische Bauteile können somit auch noch weitere Funktionen übernehmen, bspw. können sie als Kontaktelement zur Kontaktierung von Schaltungsteilen ausgeführt sein, sie können bspw. mechanischen Druck auf das Substrat ausüben, um dieses beispielsweise auf eine Kühlplatte zu drücken, und sie können bspw. auch das Substrat teilweise einfassen und so die mechanische Stabilität erhöhen. D.h. das metallische Bauteil verbindet elektrisch verschiedene Lagen einer Multilagenschaltung, deren Lagen aus einem oder mehreren anderen metallischen Bauteilen und/oder aus einer oder mehreren leitfähigen Dickfilmlagen besteht.

In einer weiteren Ausführungsform weist ferner das mindestens eine Substrat mindestens eine zweite Oberfläche, welche der mindestens einen ersten Oberfläche gegenüberliegt, auf, wobei die mindestens eine erste Oberfläche und/oder die mindestens eine zweite Oberfläche zumindest teilweise mindestens eine keramische Oberfläche aufweist, wobei sowohl auf die erste Oberfläche wie auch auf die zweite Oberfläche zumindest bereichsweise die druckfähige, metallpulverbasierte Paste aufgebracht werden kann; und wobei in beide aufgebrachten druckfähigen, metallpulverbasierten Pasten je mindestens ein metallisches Bauteil aufgelegt und eingedrückt werden kann.

Vorteilhafte Ausführung umfassend die Herstellung einer Sandwichstruktur, bei welcher die Keramik beidseitig von (bspw. strukturierten) metallischen Bauteilen durch Verbindung mit druckbarer metallbasierter Paste kraft- und förmschlüssig eingeschlossen wird. Die metallischen Bauteile nehmen in diesem Verbund Zugspannungen auf, während die Keramik Druckspannungen aufnimmt. Die Sandwichstruktur ist damit biegesteif und biegefest. Darüber hinaus wird die empfindliche Keramikoberfläche beidseitig vor mechanischen Krafteinwirkungen geschützt. Diese können beispielsweise auftreten, wenn das Substrat auf einen Kühlkörper gepresst wird und dieser nicht hinreichend plan gearbeitet ist oder sich zwischen den Presspartnern Schmutzpartikel, insbesondere Sandkörner oder Metallspäne befinden.

In weiteren Ausführungsformen ist das Substrat ein Metall-Keramikverbund, welcher zwei gegenüberliegende metallische Oberflächen aufweist; wobei die druckfähige metallpulverbasierte Paste zumindest teilweise auf mindestens eine metallische Oberfläche des Metall-Keramikverbundes aufgetragen wird; und wobei mindestens ein metallisches Bauteil in die zumindest teilweise auf mindestens eine metallische Oberfläche des Metall-Keramikverbundes aufgetragene druckfähige metallpulverbasierte Paste aufgelegt und eingedrückt wird. In dieser Ausgestaltung, werden auf ein DCB-Substrat weitere Dickfilmschichten beziehungsweise metallische Bauelemente mit Hilfe der Dickfilmtechnik aufgebracht. Der sich daraus ergebende Vorteil besteht darin, dass das DCB-Substrat nicht erst aufwendig durch Ätzprozesse hinsichtlich eines bestimmten Layouts strukturiert werden muss, sondern in großen Stückzahlen mit einfachem Layout, im einfachsten Fall einer beidseitigen Plattenstruktur, hergestellt werden kann. Die Schaltungsstruktur wird dann mittels Dickfilmtechnik und darauf aufgebrachten metallischen Bauteilen realisiert. Dies ist insbesondere vorteilhaft, wenn Al₂O₃-Keramik genutzt wird. Ihr vergleichsweise hoher thermischer Widerstand kann durch das DCB-Kupfer und das dadurch erreichte Wärmespreizen verringert werden. Darüber hinaus sorgt die Kupferfläche mit ihrer thermischen Kapazität für einen geringen dynamischen thermischen Widerstand zwischen Leistungshalbleiterchip und Kühlkörper.

In einer weiteren Ausführungsform sind die Kupferplättchen nicht ausschließlich rechteckig geformt, sondern können jede mögliche bzw. beliebige geometrische Form (sowohl in x, y und z-Richtung, d.h. in allen drei Raumrichtungen) aufweisen, d.h. bspw. können die Kupferplättchen kreisförmig, elliptisch, dreieckig, jede polygonale bzw. vieleckige Form bzw. jede beliebige geometrische Form aufweisen. Bevorzugte Formen sind Einkerbungen an den Außenkanten der Kupferplättchen um einen wie bei DCBs (dort Dimples genannt) üblichen sanften Übergang der temperaturinduzierten mechanischen Spannungen zu erreichen. Darüber hinaus sind Formen vorteilhaft, die den Pfaden höchster Stromdichte folgen und somit den Leiterquerschnitt in diesen Bereichen erhöhen.

In einer weiteren Ausführungsform kann mit dem Verfahren ein Schaltkreis mittels Löt- und/oder Sinterverbindung mit Kupferdickfilmleitern einer ersten Lage und einer zweiten Lage verbunden werden. Ebenfalls mit Kupferdickfilmleitern mehrerer Lagen können weitere oberflächenmontierbare Bauteile wie Widerstände, Kondensatoren, elektronische Bauelemente etc. verbunden werden. Bspw. kann ein Leistungshalbleiter, wie z.B. ein Transistor, mit mindestens zwei Bonddrähten mit Kupferdickfilmlagen verbunden werden, welche z.B. mit einem Gatetreiberschaltkreis elektrisch verbunden sind.

In einer weiteren Ausführungsform kann z.B. eine Modulstruktur mit in leitende Dickfilme eingebettetem LTCC-Kondensator, welcher über eine ober- und unterseitige Kupfermetallisierung verfügt, welche durch den Einbrennprozess mit den Kupferdickschichtpasten kontaktiert wird, hergestellt werden. Weiterhin können elektrisch isolierende Dickfilmpasten, die die verschiedenen elektrischen Potentiale sicher voneinander trennen, verwendet werden. Hervorzuheben ist ferner, dass die hierzu eingesetzten Dickfilme auch oben auf ein Kupferplättchen aufgebracht werden können. Des Weiteren können Verbindungselemente mit den so hergestellten Modulen verbunden werden, die den elektrischen Kontakt zu übergeordneten Schaltungsträgern herstellen.

In einer weiteren Ausführungsform kann eine Modulstruktur mit Dickfilmstrukturen auf mittels Dickfilm mit einem keramischen Trägersubstrat verbundenen Kupferplättchen gebildet werden. Auch auf diesen Kupferplättchen können wiederum Multilayer-Dickfilmstrukturen bestehend aus nicht elektrisch leitfähigen und elektrisch leitfähigen Dickfilmen aufgebracht werden. Wodurch die damit möglichen feinen Leiterstrukturen die elektrische und mechanische Kontaktierung von Integrierten Schaltkreisen (ICs) mittels Löten oder Kleben erlauben. Des Weiteren können Verbindungselemente mit den so hergestellten Modulen verbunden werden, die den elektrischen Kontakt zu übergeordneten Schaltungsträgern herstellen.

In einer weiteren Ausführungsform können Modulstrukturen mittels Kupferdickfilmpaste auf keramischem Substrat aufgebracht werden. Zusätzlich kann zumindest teilweise auch mindestens eine zweite Kupferdickfilmschicht, die mittels einer Dickfilmisolationsschicht von der ersten Kupferdickfilmschicht elektrisch isoliert ist, aufgebracht werden. Auf der zweiten Kupferdickfilmschicht kann auch mindestens eine Bondverbindung angeordnet sein, wobei der Bonddraht z.B. die zweite Kupferdickfilmschicht mit einer oberseitigen Metallisierung eines leistungselektronischen Halbleiterchips verbindet. Zusätzlich kann eine vertikal angeordnete Sandwich-Struktur gebildet sein, bspw. gebildet aus einem keramischen Substrat sowie auf dieses beidseitig mittels Kupferdickfilmschicht aufgebrachten strukturierten und geformten Kupferplättchen. Eine solche Struktur ist durch die planparallele Führung zweier Leiter mit bspw. gegensätzlicher Stromrichtung eine bevorzugte Anordnung, um die Induktivität dieser beiden Leiter zu verringern. Der Herstellungsprozess in einer Ausführungsform umfasst dabei: Ausstanzen des einen Kupferblechteils oder der mehreren Kupferblechteile, Biegen bzw. Prägen des einen Kupferblechteils oder der mehreren Kupferblechteile, beidseitiges Bedrucken mindestens eines keramischen Substrates mit Kupferdickfilmpaste und Auflegen des einen Kupferblechteils oder der mehreren Kupferblechteile, das Einbrennen dieses derart gebildeten Sandwiches. Dieses vorgefertigte Bauteil kann dann auf ein mindestens zweites, horizontales Substrat mittels des beanspruchten Verfahrens aufgebracht werden.

In einer weiteren Ausführungsform kann eine Modulstruktur mit Kupferblechen als Verbindungselementen gebildet werden. Hierzu sind Kupferbleche nicht vollflächig durch eine Kupferdickfilmpaste mit einem keramischen Substrat verbunden. Zumindest ein Teil der Kupferbleche ist bspw. im Winkel von 90° gebogen und steht somit parallel zur Flächennormale des keramischen Substrates, wobei auch jeder andere Winkel zwischen 0° und 180° hierbei Verwendung finden kann. Vorteilhaft an dieser Ausgestaltungsform ist, dass Leitungswiderstände reduziert und die Zuverlässigkeit des Aufbaus dadurch erhöht werden, dass im Vergleich zur vorhergehenden Ausführungsform weniger Löt- bzw. Dickfilmverbindungsschichten im Strompfad verwendet werden.

In einer weiteren Ausführungsform kann eine Modulstruktur mit mehreren, durch Dickfilmisolation elektrisch isolierte Kupferbleche als Verbindungselemente gebildet werden. Eine derartige Modulstruktur weist mehrere leitfähige Ebenen (Layer) auf, die jeweils als Hauptleiter ein Kupferblech aufweisen und zusammen eine Halbbrückenschaltung mit zwei Halbleiterbauelementen bilden. Unterhalb eines dabei eingesetzten Leistungshalbleiters sorgt das Kupferblech unter anderem für eine Wärmespreizung, sodass die vergleichsweise schlechte Wärmeleitfähigkeit der Dickfilmisolationslage sowie des keramischen Substrates aufgrund eines größeren effektiven Querschnitts gesteigert wird. Diese Ausführungsform hat den Vorteil, dass dabei die Induktivität des Leistungskreises durch die planare Führung in verschiedenen Ebenen der Modulstruktur reduziert wird. Die Verbindungselemente, welche mit dem Verfahren mechanisch und elektrisch mit den Kupferplättchen verbunden werden, stellen bspw. folgende Verbindungen zu einem übergeordneten Schaltungsträger her: Spannungsversorgung (+), Masse (-) und Brückenausgang. Darüber hinaus kann z.B. mindestens ein Zwischenkreiskondensator, der den Leistungskreis bestehend weiterhin aus zwei Leistungshalbleiterchips schließt, angeordnet werden. Dadurch, dass der Leistungskreis aus planparallel zueinander liegenden Flächenleitern (Kupferdickschichten sowie Kupferplättchen) besteht, wird die durch ihn erzeugte Induktivität im Vergleich zu herkömmlichen Modulen ohne Zwischenkreiskondensator und koplanare Struktur deutlich reduziert. Pro Halbbrücke, bestehend aus zwei Chips und einem Zwischenkreiskondensator können gemäß dieser Ausführungsform Induktivitäten weit unterhalb von 10 nH erreicht werden.

In einer weiteren Ausführungsform kann eine Modulstruktur gebildet werden, die auch einen sogenannten "Flip-chip" Leistungshalbleiter aufweist, dessen Oberseite durch Sintern, Kleben und/oder Löten mit Dickfilmlagen elektrisch verbunden ist. Darüber hinaus kann zumindest ein Leistungshalbleiterchip bereitgestellt sein, der oberseitig durch Sintern, Kleben und/oder Löten direkt mit einem auf ihn hinabgebogenen Kupferplättchen elektrisch verbunden ist. Das Kupferplättchen wurde vorher mittels des Verfahrens (bspw. mit der ersten Kupferdickfilmlage) am keramischen Substrat befestigt.

In einer weiteren Ausführungsform können auch Kupferdickfilmpasten genutzt werden, um kupferne Verbindungselemente (z.B. Kontaktierungspins), sowie passive Bauelemente aus Kupfer und/oder Keramik, wie zum Beispiel Induktivitäten mit einem Substrat zu verbinden. Bei Induktivitäten liegt ein Vorteil in einer guten Wärmeabfuhr aus jeder Windung, sofern diese durch eine Dickfilmschicht mit dem Substrat verbunden sind. Um diese vergleichsweise kleinen Dickfilmbereiche unterhalb der Induktivität (oder anderer Strukturen) zu realisieren, kann das Bauelement (die Induktivität) vorher in die Paste getaucht werden und "nass-in-nass" mit der auf das Substrat gedruckten Paste verbunden werden. Eine weitere Ausführungsform umfasst die Verbindung von keramischen Substraten untereinander mit Hilfe einer auf ein oder beide Substrate aufgedruckten Dickfilmschicht. Darüber hinaus können auch DCB-Substrate untereinander oder DCB Substrate mit keramischen Schaltungsträgern (mit Kupfer- oder Silberleitbahnen) mit Kupferdickschichtpasten verbunden werden. Eine weitere Ausführungsform umfasst die Struktur der Metallplättchen, welche nicht nur in ihren Abmessungen in der Ebene der Draufsicht, sondern auch in ihrer Dicke unterschiedlich geformt sein können. Vorzugsweise können Querschnittsverkleinerungen in den Randbereichen zum Abbau mechanischer Spannungen vorgesehen sein oder es können vorgefertigte Wasserkühlelemente mit internen Wasserkanälen mittels Kupferdickfilm mit dem keramischen Schaltungsträger verbunden werden. Darüber hinaus können Induktivitäten verlötet auf einem DCB-Substrat mit dem Verfahren gebildet werden. Dieses Prinzip kann demgemäß vorteilhaft auf eine erfindungsgemäße Verbindung von Kupfer- und Keramikelementen mittels des Verfahrens angewandt werden.

In einer weiteren Ausführungsform kann ein Fertigungsprozess eines Moduls aufweisen: Siebdrucken einer ersten Kupferdickfilmschicht und Trocknen dieser; Siebdrucken einer Dickfilmisolierschicht und Trocknen dieser; Siebdrucken einer zweiten Kupferdickfilmschicht, sofort danach Auflegen von gestanzten Kupferblechen, Trocknen und Einbrennen der Dickfilmpasten; Siebdrucken oder Schablonendrucken der Sinter- oder Lotpaste; Auflegen eines Halbleiterchips und Sintern oder Löten; Drahtbonden des Halbleiterchips; und Umbiegen der Kupferbleche.

In einer weiteren Ausführungsform können bspw. die Kupferplättchen auch einen kreisförmigen oder ovalen Querschnitt aufweisen, d.h. sie können aus geraden oder gebogenen Stäben bestehen, die ebenso die Abmessungen des Substrates überragen können und vor, während oder nach dem Fertigungsprozess gebogen werden können, um als Anschlusselement zu fungieren. Des Weiteren können bspw. angeraute oder anders strukturierte Unterseiten, der auf die Dickfilmschicht aufgebrachten Kupferbauteile eingesetzt werden, um die Haftung auf der Dickfilmschicht zu erhöhen, bzw. um Lufteinschlüsse'(Lunker) zu vermeiden und um eine definierte Dicke der Dickfilmschicht unter dem Kupferbauteil sicher zu stellen. Außerdem können die Kupferbauteile in die bereits getrocknete Dickfilmschicht eingepresst werden und anschließend eingebrannt werden. Weiterhin kann auch bspw. eine teilweise Trocknung von Dickfilmpasten vor der Bestückung mit Kupferelementen durchgeführt werden, wobei ein Teil der Dickfilmpaste unter den Kupferelementen, z.B. in deren Randbereichen, nass gehalten wird, um die Kupferbauteile nach ihrer Bestückung zu halten bzw. zu fixieren und anschließend die Dickfilmpaste einzubrennen. Darüber hinaus kann das Einbrennen der Substrat-Dickfilmpaste-Kupferbauteil-Stacks unter Druckapplizierung auf die Kupferbauteile erfolgen. Außerdem kann bspw. auch eine Verbindung von Silberplättchen und Keramiksubstraten gebildet werden oder untereinander mittels silberbasierten (edelmetallhaltigen) Dickfilmpasten; Verbindung von edelmetallumhüllten (versilbert, vergoldet ...) Kupferplättchen mittels edelmetallbasierter oder kupferner Dickfilmpasten mit einem keramischen Substrat oder untereinander, z.B. kann in einer weiteren Ausführungsform eine Verbindung von Kupferplättchen mit Keramiksubstrat mittels einer kupfernen Dickfilmschicht gebildet werden, wobei die der Dickfilmschicht abgewandte Seite der Kupferplättchen (d.h. die Oberseite) mit einer Edelmetallschicht (z.B. versilbert, vergoldet) überzogen ist, die die Haftung von Sinterschichten (Niedertemperatur-Silbersinterpasten) im Vergleich zu einer Kupferoberfläche steigert. In einer weiteren Ausführungsform können darüber hinaus Kupferelemente, die während der Platzierung auf der Dickfilmschicht und während des Einbrennvorgangs über Stege, welche innerhalb oder außerhalb der Modulfläche liegen können, miteinander verbunden werden, wobei nach dem Einbrennprozess zumindest ein Teil der außerhalb befindlichen Stege mechanisch und elektrisch getrennt werden (Leadframetechnik).

Vorteilhaft können alle Ausführungsformen der hierin beschriebenen und beanspruchten Vorrichtung in Kombination mit einer oder mehreren der hierin genannten und beschriebenen Ausführungsformen realisiert werden.

Weitere Ausführungsformen, deren Ausgestaltung sowie einige der Vorteile, die mit diesen und weiteren Ausführungsformen verbunden sind, werden durch die nachfolgende ausführliche Beschreibung unter Bezug auf die begleitenden Figuren detaillierter und besser verständlich. Die Figuren sind lediglich schematische Darstellungen von Ausführungsformen der Erfindung.

### Figurenbeschreibung

Dabei zeigen
- **Fig. 1**: ein schematisches Blockdiagramm einer Ausführungsform; und
- **Fig. 2**: eine schematische Darstellung einer weiteren Ausführungsform.

### Detaillierte Beschreibung

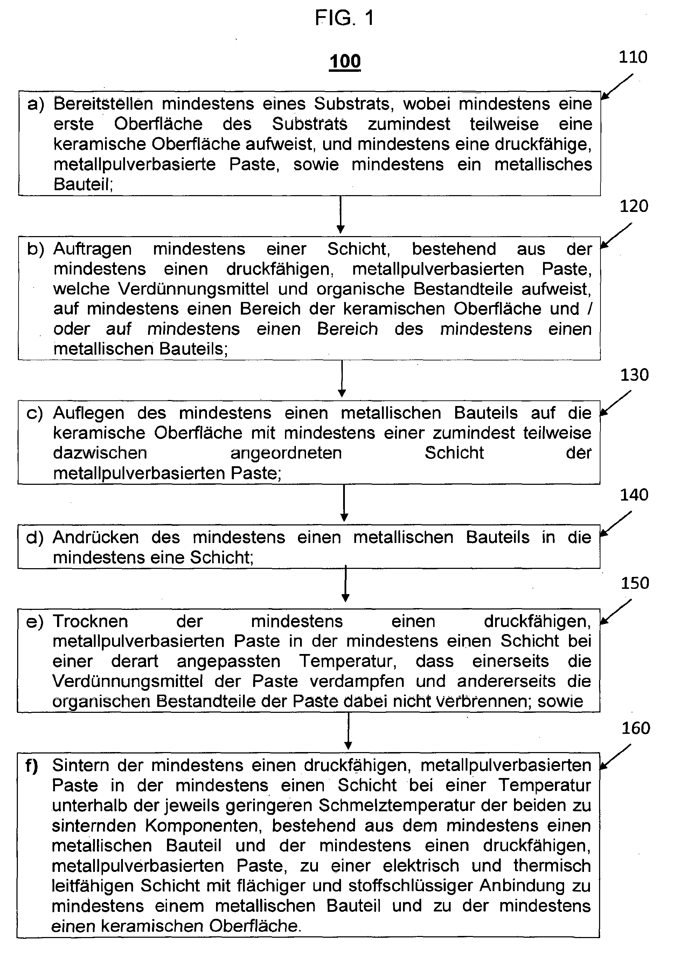

In Fig. 1 ist ein schematisches Blockdiagramm einer Ausführungsform 100 dargestellt. Hierbei weist das Verfahren 100 auf:
Bereitstellen mindestens eines Substrats, wobei mindestens eine erste Oberfläche des Substrats zumindest teilweise eine keramische Oberfläche aufweist, und mindestens eine druckfähige, metallpulverbasierte Paste, sowie mindestens ein metallisches Bauteil 110.

Das mindestens eine Substrat ist aus mindestens einem Substratmaterial aus der Gruppe von Substratmaterialien gebildet, wobei diese Gruppe aufweist: Oxidkeramiken und Nichtoxidkeramiken, bspw. Aluminiumnitrid (AlN), Siliziumnitrid (Si3N4), Aluminiumoxid (Al₂O₃), Zirconiumdioxid (ZrO₂), Titan(IV)-Oxid (TiO₂), Magnesiumoxid (MgO), Zinkoxid (ZnO), Aluminiumtitanat (Al₂O₃ + TiO₂) und Bariumtitanat (BaO + TiO₂).

Mindestens ein Teil mindestens einer Oberfläche des Substrats ist aus einem keramischen Werkstoff gebildet oder mit mindestens einem Teil mindestens einer keramischen Oberfläche des Substrats fest verbunden. Der keramische Werkstoff ist aus mindestens einem keramischen Werkstoff aus der Gruppe von oxidischen keramischen Werkstoffen gebildet, wobei diese
Gruppe aufweist: Aluminiumoxid (Al₂O₃),
Zirconiumdioxid (ZrO₂), Titan(IV)-Oxid (TiO₂),
Magnesiumoxid (MgO), Zinkoxid (ZnO),
Aluminiumtitanat (Al₂O₃ + TiO₂) und
Bariumtitanat (BaO + TiO₂).

Die mindestens eine druckfähige, metallpulverbasierte Paste weist zumindest teilweise ein Metall aus der Gruppe von Metallen auf, wobei diese Gruppe aufweist: Kupfer, Silber, Gold, Aluminium, Palladium bzw. Legierungen der zuvor genannten Metalle.

Das mindestens eine metallische Bauteil ist mindestens aus einem metallischen Werkstoff aus der Gruppe von metallischen Werkstoffen gebildet, wobei diese Gruppe aufweist: Kupfer, Silber, Gold, Nickel bzw. Legierungen der zuvor genannten Metalle.

Auftragen mindestens einer ersten Schicht, bestehend aus der mindestens einen druckfähigen, metallpulverbasierten Paste, welche zumindest teilweise Verdünnungsmittel und organische Bestandteile aufweist, auf mindestens einen Bereich der keramischen Oberfläche und/oder auf mindestens einen Bereich des mindestens einen metallischen Bauteils 120.

Die mindestens eine erste Schicht wird mittels mindestens eines Auftrageverfahrens aus der Gruppe von Auftrageverfahren auf mindestens einen Bereich der keramischen Oberfläche und/oder auf mindestens einen Bereich des mindestens einen metallischen Bauteils aufgebracht, wobei diese Gruppe von Auftrageverfahren aufweist: Siebdruck, Schablonendruck bzw. Direktschreibverfahren, wie z.B. Inkjetdruck.

Die mindestens eine erste Schicht wird dabei mindestens in einer Schichtdicke aufgebracht, wobei die Schichtdicke in einem Bereich von ungefähr 10 µm bis ungefähr 50 µm liegt.

Auflegen des mindestens einen metallischen Bauteils auf die keramische Oberfläche mit mindestens einer zumindest teilweise dazwischen angeordneten Schicht der metallpulverbasierten Paste 130.

Das Auflegen kann entweder ohne zusätzlichen Druck erfolgen oder mit einem zusätzlichen Druck.

In einer weiteren Ausführungsform erfolgt das Auflegen des mindestens einen metallischen Bauteils auf die keramische Oberfläche mit.mindestens einer zumindest teilweise dazwischen angeordneten Schicht der metallpulverbasierten Paste mittels mindestens eines Pick-and-Place-Verfahrens.

Andrücken des mindestens einen metallischen Bauteils in die mindestens eine Schicht 140.

Das Andrücken erfolgt entweder mit einem zusätzlichen zuvor bestimmten Druck oder ohne zusätzlichen Druck.

Der Druck ist dabei derart angepasst, dass das metallische Bauteil zumindest teilweise in die mindestens eine Schicht hineinragt bzw. darin eingedrückt ist.

In einer weiteren Ausführungsform kann der Druck dabei derart angepasst sein, dass das metallische Bauteil zumindest in einem Bereich derart in die mindestens eine Schicht hineinragt bzw. darin eingedrückt ist, dass das metallische Bauteil zumindest in einem Bereich von ungefähr 5 % bis ungefähr 33 % von der Schichtdicke der mindestens einen ersten Schicht liegt.

In einer weiteren Ausführungsform kann der Druck derart angepasst sein, dass der Druck hierbei zumindest in einem Bereich von ungefähr 0,01 N/mm² bis ungefähr 0,3 N/mm² liegt.

Trocknen der mindestens einen druckfähigen, metallpulverbasierten Paste in der mindestens einen Schicht bei einer derart angepassten Temperatur, dass einerseits die Verdünnungsmittel der Paste verdampfen und andererseits die organischen Bestandteile der Paste dabei nicht verbrennen 150.

Die jeweils zuvor bestimmte Temperatur zum Trocknen ist derart angepasst, dass einerseits die Lösungs- bzw. Verdünnungsmittel der Paste verdampfen und andererseits die festen, bzw. flüssigen organischen Bestandteile der Paste dabei nicht verbrennen, d.h. die Verdünnungsmittel in der Paste erfordern eine niedrigere Temperatur zum Verdampfen als die Temperatur, die zum Verbrennen der organischen Bestandteile in der Paste notwendig ist.

Das Trocknen der mindestens einen druckfähigen, metallpulverbasierten Paste in der mindestens einen Schicht erfolgt mittels mindestens eines thermischen Verfahrens, wobei in einer weiteren Ausführungsform die Temperatur hierfür in einem Bereich von ungefähr 100 °C bis ungefähr 250 °C liegt.

Sintern der mindestens einen druckfähigen, metallpulverbasierten Paste in der mindestens einen Schicht bei einer Temperatur unterhalb der jeweils geringeren Schmelztemperatur der beiden zu sinternden Komponenten, bestehend aus dem mindestens einen metallischen Bauteil und der mindestens einen druckfähigen, metallpulverbasierten Paste, zu einer elektrisch und thermisch leitfähigen Schicht mit flächiger und stoffschlüssiger Anbindung zu mindestens einem metallischen Bauteil und zu der mindestens einen keramischen Oberfläche 160.

Das Sintern erfolgt in einer weiteren Ausführungsform bei einer zuvor bestimmten Temperatur, wobei die Temperatur hierfür in einem Bereich von ungefähr 900 °C bis ungefähr 1000 °C liegt

Das Sintern erfolgt bei einer jeweils zuvor bestimmten Temperatur in Abhängigkeit der verwendeten Komponenten, d.h. zumindest dem mindestens einen metallischen Bauteil und der mindestens einen druckfähigen, metallpulverbasierten Paste derart, dass sich anschließend an das Sintern eine elektrisch und thermisch leitfähigen Schicht mit flächiger und stoffschlüssiger Anbindung zu dem mindestens einen metallischen Bauteil und zu der mindestens einen keramischen Oberfläche bildet. D.h. dass die zuvor bestimmte Temperatur, die für das Sintern gewählt wird, jeweils unterhalb der jeweils geringeren Schmelztemperatur der beiden zu sinternden Komponenten liegt.

In einer weiteren Ausführungsform liegt die Temperatur für das Sintern in einem Bereich von ungefähr 930 °C bis ungefähr 980 °C.

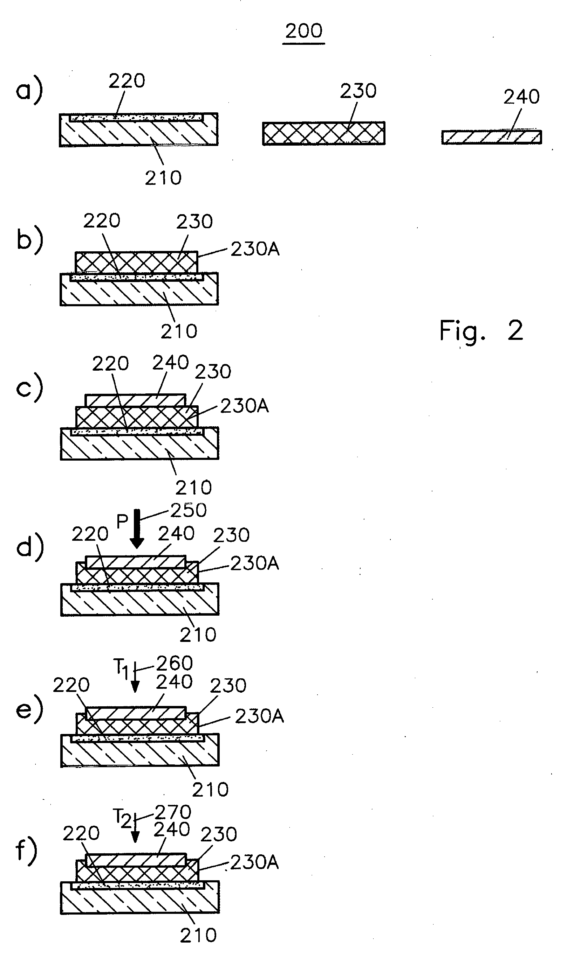

In Fig. 2 ist eine schematische Darstellung einer weiteren Ausführungsform 200 gezeigt. In der Ausführungsform 200 können alle Komponenten, Verfahrensschritte, Prozessschritte, Verfahren, Bauteile bzw. Materialien entsprechend bzw. gemäß den zuvor genannten bzw. erläuterten Komponenten, Verfahrensschritten, Prozessschritten, Verfahren, Bauteilen bzw. Materialien der Ausführungsform 100 gebildet sein bzw. erfolgen.

Hierbei ist in Figur 2a) das Bereitstellen mindestens eines Substrats 210, wobei mindestens eine erste Oberfläche des Substrats zumindest teilweise eine keramische Oberfläche 220 aufweist, und mindestens eine druckfähige, metallpulverbasierte Paste 230, sowie mindestens ein metallisches Bauteil 240 dargestellt.

Das metallische Bauteil 240 kann in einer weiteren Ausführungsform wiederum derart gebildet sein, dass es zumindest teilweise als ein elektrisches Bauteil geformt ist. Beispielsweise kann es zumindest als ein Teil eines elektrischen Anschlusses gebildet sein. Darüber hinaus kann das metallische Bauteil 240 auch ein vollständiges elektrisches Bauteil sein.

In einer Ausführungsform erfolgt das in Figur 2a) schematisch dargestellte Bereitstellen des Substrats 210 mit mindestens einer ersten Oberfläche, die zumindest teilweise eine keramische Oberfläche 220 aufweist, und mindestens einer druckfähigen, metallpulverbasierte Paste 230, sowie mindestens eines metallischen Bauteils 240 gemäß dem zuvor beschriebenen Verfahrensschritt 110 der Ausführungsform 100.

In Figur 2b) ist das Auftragen mindestens einer Schicht 230A, bestehend aus der mindestens einen druckfähigen, metallpulverbasierten Paste 230, welche Verdünnungsmittel und organische Bestandteile aufweist, auf mindestens einen Bereich der keramischen Oberfläche 220 und/oder auf mindestens einen Bereich des mindestens einen metallischen Bauteils 240 dargestellt.

In einer Ausführungsform erfolgt das in Figur 2b) schematisch dargestellte Auftragen mindestens einer Schicht 230A, bestehend aus der mindestens einen druckfähigen, metallpulverbasierten Paste 230, welche Verdünnungsmittel und organische Bestandteile aufweist, auf mindestens einen Bereich der keramischen Oberfläche 220 und/oder auf mindestens einen Bereich des mindestens einen metallischen Bauteils 240 gemäß dem zuvor beschriebenen Verfahrensschritt 120 der Ausführungsform 100.

In Figur 2c) ist das Auflegen des mindestens einen metallischen Bauteils 240 auf die keramische Oberfläche 220 mit mindestens einer zumindest teilweise dazwischen angeordneten Schicht 230A der metallpulverbasierten Paste 230 dargestellt.

In einer Ausführungsform erfolgt das in 2c) schematisch dargestellte Auflegen des mindestens einen metallischen Bauteils 240 auf die keramische Oberfläche 220 mit mindestens einer zumindest teilweise dazwischen angeordneten Schicht 230A der metallpulverbasierten Paste 230 gemäß dem zuvor beschriebenen Verfahrensschritt 130 der Ausführungsform 100.

In Figur 2d) ist das Andrücken des mindestens einen metallischen Bauteils 240 in die mindestens eine Schicht 230A dargestellt, wobei das Andrücken mit einem Druck P auf das metallische Bauteil 240 erfolgt.

In einer Ausführungsform erfolgt das in 2d) schematisch dargestellte Andrücken des mindestens einen metallischen Bauteils 240 in die mindestens eine Schicht 230A, wobei das Andrücken mit einem Druck P auf das metallische Bauteil 240 erfolgt, gemäß dem zuvor beschriebenen Verfahrensschritt 140 der Ausführungsform 100.

In Figur 2e) ist das Trocknen der mindestens einen druckfähigen, metallpulverbasierten Paste 230 in der mindestens einen Schicht 230A bei einer derart angepassten Temperatur T₁, dass einerseits die Verdünnungsmittel der Paste 230 verdampfen und andererseits die organischen Bestandteile der Paste 230 dabei nicht verbrennen, dargestellt.

In einer Ausführungsform erfolgt das in Figur 2e) schematisch dargestellte Trocknen der mindestens einen druckfähigen, metallpulverbasierten Paste 230 in der mindestens einen Schicht 230A bei einer derart angepassten Temperatur T₁, dass einerseits die Verdünnungsmittel der Paste 230 verdampfen und andererseits die organischen Bestandteile der Paste 230 dabei nicht verbrennen, gemäß dem zuvor beschriebenen Verfahrensschritt 150 der Ausführungsform 100.

In Figur 2f) ist das Sintern der mindestens einen druckfähigen, metallpulverbasierten Paste 230 in der mindestens einen Schicht 230A bei einer Temperatur T₂ unterhalb der jeweils geringeren Schmelztemperatur der beiden zu sinternden Komponenten, bestehend aus dem mindestens einen metallischen Bauteil 240 und der mindestens einen druckfähigen, metallpulverbasierten Paste 230, zu einer elektrisch und thermisch leitfähigen Schicht mit flächiger und stoffschlüssiger Anbindung zu mindestens einem metallischen Bauteil 240 und zu der mindestens einen keramischen Oberfläche 220 dargestellt.

In einer Ausführungsform erfolgt das in 2f) schematisch dargestellte Sintern der mindestens einen druckfähigen, metallpulverbasierten Paste 230 in der mindestens einen Schicht 230A bei einer Temperatur T₂ unterhalb der jeweils geringeren Schmelztemperatur der beiden zu sinternden Komponenten, bestehend aus dem mindestens einen metallischen Bauteil 240 und der mindestens einen druckfähigen, metallpulverbasierten Paste 230, zu einer elektrisch und thermisch leitfähigen Schicht mit flächiger und stoffschlüssiger Anbindung zu mindestens einem metallischen Bauteil 240 und zu der mindestens einen keramischen Oberfläche 220 gemäß dem zuvor beschriebenen Verfahrensschritt 160 der Ausführungsform 100.

In einer weiteren Ausführungsform wird anschließend an mindestens eine der oben besprochenen Ausführungsformen 100 und/oder 200 zusätzlich mindestens ein Schaltungsträger und/oder mindestens ein Schaltungselement und/oder mindestens eine elektronische Baugruppe auf das mindestens eine metallische Bauteil (240) und/oder auf Bereiche der druckfähigen, metallpulverbasierten Paste (230), welche nicht durch das mindestens eine metallische Bauteil (240) und/oder einen Bereich der keramischen Oberfläche (220) bedeckt sind, aufgebracht bzw. angeordnet und stoffschlüssig verbunden, wobei das stoffschlüssige Verbinden des mindestens einen metallischen Bauteils (240) und/oder der Bereiche der druckfähigen, metallpulverbasierten Paste (230), welche nicht durch das mindestens eine metallische Bauteil (240) und/oder einen Bereich der keramischen Oberfläche (220) bedeckt sind, mit dem mindestens einen Schaltungsträger und/oder dem mindestens einen Schaltungselementsund/oder der mindestens einen elektrischen Baugruppe bei einer Temperatur (T2) unterhalb der Schmelztemperatur der jeweils geringeren Schmelztemperatur der beiden zu sinternden Komponenten, bestehend aus dem mindestens einen metallischen Bauteil (240) und der mindestens einen druckfähigen, metallpulverbasierten Paste (230), erfolgt.

Es können in weiteren Ausführungsformen dabei auch immer mehrere Schaltungsträger, Schaltungselemente und/oder elektronische Baugruppen eingesetzt bzw. angeordnet werden.

Hierbei ist der mindestens eine Schaltungsträger zumindest ein Schaltungsträger aus der Gruppe von Schaltungsträgern, wobei die Gruppe aufweist: Leiterplatten (PCB), Metallkernleiterplatten (IMS), flexible Leiterplatten (Flexboard).

Hierbei ist das mindestens eine Schaltungselement zumindest ein Schaltungselement aus der Gruppe von Schaltungselementen, wobei diese Gruppe aufweist: Steckverbinder, Leiterbrücken, Schraubbolzen.

Hierbei weist die mindestens eine elektronische Baugruppe zumindest eine Komponente aus der Gruppe von Elektronikkomponenten auf, wobei diese Gruppe aufweist: Transistoren (BJT, JFET, MOSFET, IGBT, HEMT), Dioden, Integrierte Schaltkreise (ICs).

In einer weiteren Ausführungsform kann an das zuvor beschriebene Aufbringen und stoffschlüssige Verbinden mindestens eines Schaltungsträgers und/oder mindestens eines Schaltungselements und/oder mindestens einer elektronischen Baugruppe auf das mindestens eine metallische Bauteil (240) und/oder auf Bereiche der druckfähigen, metallpulverbasierten Paste (230), welche nicht durch das mindestens eine metallische Bauteil (240) und/oder einen Bereich der keramischen Oberfläche (220) bedeckt sind; aufgebracht bzw. angeordnet und stoffschlüssig verbunden, wobei das stoffschlüssige Verbinden des mindestens einen metallischen Bauteils (240) und/oder auf Bereiche der druckfähigen, metallpulverbasierten Paste (230), welche nicht durch das mindestens eine metallische Bauteil (240) und/oder einen Bereich der keramischen Oberfläche (220) bedeckt sind, mit dem mindestens einen Schaltungsträger und/oder dem mindestens einen Schaltungselement und/oder der mindestens einen elektrischen Baugruppe bei einer Temperatur (T2) unterhalb der Schmelztemperatur der jeweils geringeren Schmelztemperatur der beiden zu sinternden Komponenten, bestehend aus dem mindestens einen metallischen Bauteil (240) und der mindestens einen druckfähigen, metallpulverbasierten Paste (230), ferner derart erfolgen, dass das stoffschlüssige Verbinden mittels mindestens einer Verbindungstechnik aus der Gruppe von Verbindungstechniken erfolgt, wobei diese Gruppe aufweist: Löten, Kleben und/oder einen diffusionsgesteuerten Prozess.

Der zuvor genannte diffusionsgesteuerte Prozess ist zumindest ein Prozess aus der Gruppe von diffusionsgesteuerten Prozessen, wobei diese Gruppe aufweist: Drucksintern, druckloses Sintern, Diffusionslöten.

In einer weiteren Ausführungsform gemäß mindestens einer der zuvor beschriebenen Ausführungsformen besteht die mindestens eine keramische Oberfläche (220) des mindestens einen Substrats (210) aus einer Oxidkeramik und das mindestens eine metallische Bauteil (240) aus Kupfer und/oder einer Kupferlegierung, wobei die druckfähige, metallpulverbasierte Paste (230) beim Sintern eine metallische Verbindung mit dem mindestens einen metallischen Bauteil (240) und eine adhäsive und/oder oxidische Verbindung mit der mindestens einen keramischen Oberfläche (220) eingeht und wobei das Sintern in einer vorwiegend inerten Atmosphäre erfolgt.

Hierbei erfolgt das Sintern in einer vorwiegend inerten Atmosphäre, wobei diese Atmosphäre dadurch geschaffen wird, dass dabei ein inertes Gas eingesetzt wird und wobei das inerte Gas mindestens ein Gas aus der Gruppe von Gasen ist, wobei diese Gruppe aufweist: Stickstoff (N₂), Helium, Neon, Argon, Krypton, Xenon, Radon.

In einer weiteren Ausführungsform gemäß mindestens einer der zuvor beschriebenen Ausführungsformen erfolgt das Auftragen der mindestens einen druckfähigen, metallpulverbasierten Paste (230) mittels eines Schablonen- und/oder Siebdruckverfahrens oder/und eines Direktschreibverfahrens.

Hierbei kommt ein Direktschreibverfahren zum Einsatz, welches mindestens ein Direktschreibverfahren aus der Gruppe von Direktschreibverfahren aufweist, wobei diese Gruppe aufweist: Inkjetdruck und Aerosoldruck.

In einer weiteren Ausführungsform gemäß mindestens einer der zuvor beschriebenen Ausführungsformen ist das mindestens eine metallische Bauteil (240) im Anschluss an das Auflegen zumindest bereichsweise parallel zu der mindestens einen keramischen Oberfläche (220) ausgerichtet und es wird während des Auflegens Druck (P) auf das mindestens eine metallische Bauteil (240) in Richtung des mindestens einen Substrats (210) ausgeübt.

In einer weiteren Ausführungsform gemäß mindestens einer der zuvor beschriebenen Ausführungsformen wird/werden zusätzlich, zumindest teilweise, mindestens eine druckfähige, nichtmetallpulverbasierte Paste (230) oder zusätzlich eine druckfähige, metallpulverbasierte Paste in einer (230A) oder mehreren Schichten auf der druckfähigen, metallpulverbasierten Paste (230) übereinander aufgebracht.

In einer weiteren Ausführungsform gemäß mindestens einer der zuvor beschriebenen Ausführungsformen wird zusätzlich, zumindest teilweise, mindestens ein zweites metallisches Bauteil auf eine auf mindestens ein erstes metallisches Bauteil (240) aufgebrachte druckfähige, nichtmetallpulverbasierte Paste (230) oder eine druckfähige, metallpulverbasierte Paste aufgelegt und eingedrückt.

Das metallische Bauteil kann hierbei gemäß einem der zuvor beschriebenen Ausgestaltungen in mindestens einer der zuvor beschriebenen Ausführungsformen gebildet sein.

Darüber hinaus können auch eine Vielzahl gleicher oder auch unterschiedlicher metallischer Bauteile verwendet werden.

In einer weiteren Ausführungsform gemäß mindestens einer der zuvor beschriebenen Ausführungsformen wird das mindestens eine metallische Bauteil (240) vor oder/und nach dem Auflegen auf die druckfähige, metallpulverbasierte Paste (230) mittels mindestens eines mechanischen oder/und chemischen Prozesses strukturiert und/oder mechanisch verformt, wobei das mindestens eine metallische Bauteil (240) nach dem Auflegen auf die druckfähige, metallpulverbasierte Paste (230) zumindest zwei Bereiche zumindest einer keramischen Oberfläche (220) und/oder zumindest einer metallischen Oberfläche eines zumindest zweiten metallischen Bauelements elektrisch verbindet.

Die Struktur, die hierdurch gebildet wird, weist mindestens eine Struktur'aus der Gruppe von Strukturen auf, wobei diese Gruppe aufweist: parallele Vertiefungen, kreuzend angeordnete parallele Vertiefungen oder Vertiefungen in einer Mäanderstruktur usw.

Der mindestens eine mechanische oder/und chemische Prozess zum Strukturieren erfolgt mittels mindestens eines Strukturierungsverfahrens aus der Gruppe von Strukturierungsverfahren, wobei diese Gruppe aufweist: Ätzen, Prägen, Walzen, Pressen, Stanzen.

In einer weiteren Ausführungsform gemäß mindestens einer der zuvor beschriebenen Ausführungsformen weist ferner das mindestens eine Substrat (210) mindestens eine zweite Oberfläche, welche der mindestens einen ersten Oberfläche gegenüberliegt, auf; wobei die mindestens eine erste Oberfläche und/oder die mindestens eine zweite Oberfläche zumindest teilweise mindestens eine keramische Oberfläche aufweist; wobei sowohl auf die erste Oberfläche wie auch auf die zweite Oberfläche zumindest bereichsweise die druckfähige, metallpulverbasierte Paste aufgebracht werden kann; und wobei in beide aufgebrachte druckfähige, metallpulverbasierte Pasten je mindestens ein metallisches Bauteil aufgelegt und eingedrückt werden kann.

Hierbei sind die mindestens eine zweite keramische Oberfläche und alle metallischen Bauteile gemäß einer der zuvor beschriebenen Ausführungsformen gebildet.

In einer weiteren Ausführungsform gemäß mindestens einer der zuvor beschriebenen Ausführungsformen ist das Substrat (210) ein Metall-Keramikverbund, welcher zwei gegenüberliegende metallische Oberflächen aufweist; wobei die druckfähige metallpulverbasierte Paste (230) zumindest teilweise auf mindestens eine metallische Oberfläche des Metall-Keramikverbundes aufgetragen wird; und wobei mindestens ein metallisches Bauteil (240) in die zumindest teilweise auf mindestens eine metallische Oberfläche des Metall-Keramikverbundes aufgetragene druckfähige metallpulverbasierte Paste (230) aufgelegt und eingedrückt wird.

Der Metall-Keramikverbund ist aus mindestens einem Metall-Keramikverbund aus der Gruppe von Metall-Keramikverbünden gebildet, wobei diese Gruppe aufweist: Direct Copper Bond (DCB) Substrat, Active Metal Brazed (AMB) Substrat, Kupferdickfilm (CTF) Substrat, Copper plate-up Substrat.

## Patentansprüche

1. Verfahren (100, 200), umfassend folgende Verfahrensschritte
a) Bereitstellen mindestens eines Substrats (210), wobei mindestens eine erste Oberfläche des Substrats zumindest teilweise eine keramische Oberfläche (220) aufweist, und mindestens eine druckfähige, metallpulverbasierte Paste (230), sowie mindestens ein metallisches Bauteil (240) - (110);
b) Auftragen mindestens einer Schicht (230A), bestehend aus der mindestens einen druckfähigen, metallpulverbasierten Paste (230), welche Verdünnungsmittel und organische Bestandteile aufweist, auf mindestens einen Bereich der keramischen Oberfläche (220) und/oder auf mindestens einen Bereich des mindestens einen metallischen Bauteils (240) - (120);
c) Auflegen des mindestens einen metallischen Bauteils (240) auf die keramische Oberfläche (220) mit mindestens einer zumindest teilweise dazwischen angeordneten Schicht (230A) der metallpulverbasierten Paste (230) - (130);
d) Andrücken des mindestens einen metallischen Bauteils (240) in die mindestens eine Schicht (230A) - (140);
e) Trocknen der mindestens einen druckfähigen, metallpulverbasierten Paste in der mindestens einen Schicht bei einer derart angepassten Temperatur, dass einerseits die Verdünnungsmittel der Paste (230) verdampfen und andererseits die organischen Bestandteile der Paste (230) dabei nicht verbrennen - (150); sowie
f) Sintern der mindestens einen druckfähigen, metallpulverbasierten Paste (230) in der mindestens einen Schicht (230A) bei einer Temperatur (T₂) unterhalb der jeweils geringeren Schmelztemperatur der beiden zu sinternden Komponenten, bestehend aus dem mindestens einen metallischen Bauteil (240) und der mindestens einen druckfähigen, metallpulverbasierten Paste (230), zu einer elektrisch und thermisch leitfähigen Schicht mit flächiger und stoffschlüssiger Anbindung zu mindestens einem metallischen Bauteil (240) und zu der mindestens einen keramischen Oberfläche (220) - (160).

2. Verfahren gemäß Anspruch 1, ferner aufweisend:
a) anschließendes Aufbringen und stoffschlüssiges Verbinden mindestens eines Schaltungsträgers und/oder mindestens eines Schaltungselements und/oder mindestens einer elektronischen Baugruppe auf das mindestens eine metallische Bauteil (240) und/oder auf Bereiche der druckfähigen, metallpulverbasierten Paste (230), welche nicht durch das mindestens eine metallische Bauteil (240) und/oder einen Bereich der keramischen Oberfläche (220) bedeckt sind; und
b) wobei das stoffschlüssige Verbinden des mindestens einen metallischen Bauteils (240) und/oder auf Bereiche der druckfähigen, metallpulverbasierten Paste (230), welche nicht durch das mindestens eine metallische Bauteil (240) und/oder einen Bereich der keramischen Oberfläche (220) bedeckt sind, mit dem mindestens einen Schaltungsträger und/oder dem mindestens einen Schaltungselements und/oder der mindestens einen elektrischen Baugruppe bei einer Temperatur (T₂) unterhalb der Schmelztemperatur der jeweils geringeren Schmelztemperatur der beiden zu sinternden Komponenten, bestehend aus dem mindestens einen metallischen Bauteil (240) und der mindestens einen druckfähigen, metallpulverbasierten Paste (230), erfolgt.

3. Verfahren (100, 200) gemäß Anspruch 2, wobei ferner das stoffschlüssige Verbinden mittels mindestens einer Verbindungstechnik aus einer Gruppe von Verbindungstechniken erfolgt, wobei diese Gruppe von Verbindungstechniken aufweist: Löten, Kleben und/oder einen diffusionsgesteuerten Prozess.

4. Verfahren (100, 200) gemäß mindestens einem der vorgenannten Ansprüche,
a) wobei die mindestens eine keramische Oberfläche (220) des mindestens einen Substrats (210) aus einer Oxidkeramik und das mindestens eine metallische Bauteil (240) aus Kupfer und/oder einer Kupferlegierung bestehen, wobei die druckfähige, metallpulverbasierte Paste (230) beim Sintern eine metallische Verbindung mit dem mindestens einen metallischen Bauteil (240) und eine adhäsive Verbindung mit der mindestens einen keramischen Oberfläche (220) eingeht; und
b) wobei das Sintern in einer vorwiegend inerten Atmosphäre erfolgt.

5. Verfahren (100, 200) gemäß mindestens einem der vorgenannten Ansprüche, wobei das Auftragen der mindestens einen druckfähigen, metallpulverbasierten Paste (230) mittels eines Siebdruckverfahrens oder/und eines Direktschreibverfahrens erfolgt.

6. Verfahren (100, 200) gemäß mindestens einem der vorgenannten Ansprüche, wobei das mindestens eine metallische Bauteil (240) im Anschluss an das Auflegen zumindest bereichsweise parallel zu der mindestens einen keramischen Oberfläche (220) ausgerichtet ist und während des Auflegens Druck (P) auf das mindestens eine metallische Bauteil (240) in Richtung des mindestens einen Substrats (210) ausgeübt wird.

7. Verfahren (100, 200) gemäß mindestens einem der vorgenannten Ansprüche, wobei zusätzlich, zumindest teilweise, mindestens eine druckfähige, nichtmetallpulverbasierte Paste (230) oder zusätzlich eine druckfähige, metallpulverbasierte Paste in einer Schicht (230A) oder mehreren Schichten auf der druckfähigen, metallpulverbasierten Paste (230) übereinander aufgebracht wird/werden.

8. Verfahren (100, 200) gemäß mindestens einem der vorgenannten Ansprüche, wobei zusätzlich, zumindest teilweise, mindestens ein zweites metallisches Bauteil auf eine auf mindestens ein erstes metallisches Bauteil (240) aufgebrachte druckfähige, nichtmetallpulverbasierte Paste (230) oder eine druckfähige, metallpulverbasierte Paste aufgelegt und eingedrückt wird.

9. Verfahren (100, 200) gemäß mindestens einem der vorgenannten Ansprüche,
a) wobei das mindestens eine metallische Bauteil (240) vor oder/und nach dem Auflegen auf die druckfähige, metallpulverbasierte Paste (230) mittels mindestens eines mechanischen oder/und chemischen Prozesses strukturiert und/oder mechanisch verformt wird,
b) wobei das mindestens eine metallische Bauteil (240) nach dem Auflegen auf die druckfähige, metallpulverbasierte Paste (230) zumindest zwei Bereiche zumindest einer keramischen Oberfläche (220) und/oder zumindest einer metallischen Oberfläche eines zumindest zweiten metallischen Bauelements elektrisch verbindet.

10. Verfahren (100, 200) gemäß mindestens einem der vorgenannten Ansprüche,
a) wobei ferner das mindestens eine Substrat (210) mindestens eine zweite Oberfläche, welche der mindestens einen ersten Oberfläche gegenüberliegt, aufweist;
b) wobei die mindestens eine erste Oberfläche und/oder die mindestens eine zweite Oberfläche zumindest teilweise mindestens eine keramische Oberfläche aufweist;
c) wobei sowohl auf die erste Oberfläche wie auch auf die zweite Oberfläche zumindest bereichsweise die druckfähige, metallpulverbasierte Paste aufgebracht werden kann; und
d) wobei in beide aufgebrachte druckfähige, metallpulverbasierte Pasten je mindestens ein metallisches Bauteil aufgelegt und eingedrückt werden kann.

11. Verfahren (100, 200) gemäß mindestens einem der vorgenannten Ansprüche,
a) wobei das Substrat (210) ein Metall-Keramikverbund ist, welcher zwei gegenüberliegende metallische Oberflächen aufweist;
b) wobei die druckfähige metallpulverbasierte Paste (230) zumindest teilweise auf mindestens eine metallische Oberfläche des Metall-Keramikverbundes aufgetragen wird; und
c) wobei mindestens ein metallisches Bauteil (240) in die zumindest teilweise auf mindestens eine metallische Oberfläche des Metall-Keramikverbundes aufgetragene druckfähige metallpulverbasierte Paste (230) aufgelegt und eingedrückt wird.
